# EUROPÄISCHE PATENTANMELDUNG

(11) **EP 2 330 873 A1**
(43) Veröffentlichungstag der Anmeldung: **08.06.2011**
(21) Anmeldenummer: 10191331.7
(22) Anmeldetag: 16.11.2010
(51) Int. Cl.: H05K 1/02, H01L 23/473, H05K 7/20

(54) **Elektronisches Modul**

(30) Priorität: 03.12.2009 DE 102009056782
(71) Anmelder: Continental Automotive GmbH, 30165 Hannover (DE)
(72) Erfinder: Baur, Frank, 90482 Nürnberg (DE); Brey, Roland, 93458 Eschlkam (DE)

(57) **Zusammenfassung**

Die Erfindung beschreibt ein elektronisches Modul (1), umfassend eine Leiterplatte (10) mit einer Leiterzugstruktur und zumindest einer Aufnahmefläche (16). Weiterhin umfasst das erfindungsgemäße elektronische Modul (1) zumindest ein elektronisches Bauelement (30), das auf der zumindest einen Aufnahmefläche (16) angeordnet und elektrisch mit der Leiterzugstruktur verbunden ist. Schließlich umfasst die Erfindung eine in der Leiterplatte (10) ausgebildete Kühlmittelführungsstruktur (17), in welcher im Betrieb des elektronischen Moduls (1) ein Kühlmedium zirkuliert, wobei ein Abschnitt der Kühlmittelführungsstruktur (17) im Bereich der zumindest einen Aufnahmefläche (16) durch eine Wand (20) der Leiterplatte (10) und eine Fläche (21) des elektronischen Bauelements (30) ausgebildet ist.

## Beschreibung

### Beschreibung

### Elektronisches Modul

Die Erfindung betrifft ein elektronisches Modul, das mit einer Leiterplatte mit einer Leiterzugstruktur und mit zumindest einem elektronisches Bauelement, das auf einer Aufnahmefläche der Leiterplatte angeordnet und elektrisch mit der Leiterzugstruktur verbunden ist gebildet ist. In der Leiterplatte ist eine an eine Wärmesenke angebundene Kühlmittelführungsstruktur ausgebildet, in welcher im Betrieb des elektronischen Moduls ein Kühlmedium zirkuliert, wobei ein Abschnitt der Kühlmittelführungsstruktur im Bereich der zumindest einen Aufnahmefläche durch eine Wand der Leiterplatte und eine Fläche des elektronischen Bauelements ausgebildet ist.

Ein solches elektronisches Modul ist aus der EP 1 628 515 A1 bekannt. Dieses ist mit einer Basis gebildet, auf deren Oberfläche eine Kühlmittelpumpe direkt angeordnet ist.

Im Betrieb weisen elektronische Bauelemente, wie z.B. Halbleiterschaltelemente, integrierte Schaltungen und dergleichen, eine hohe Verlustleistung auf, so dass sich diese zum Teil stark erwärmen. Lokal können dabei derart hohe Temperaturen auftreten, dass das elektronische Bauelement selbst oder die elektrische Verbindung des elektronischen Bauelements zu der Leiterplatte beschädigt wird. Punkte mit lokalen Temperaturspitzen werden als sog. Hotspots bezeichnet. Insbesondere die an diesen Punkten entstehende Wärme muss von den elektronischen Bauelementen weggeführt werden, um die Zuverlässigkeit und die Lebensdauer über einen geforderten Zeitraum sicherstellen zu können.

Um eine Eigenerwärmung über einen kritischen Temperaturwert hinaus während des Betriebs des elektronischen Moduls zu verhindern, werden typischerweise Wärme leitende Materialien eingesetzt, um die Wärme vom Entstehungsort wegzuleiten. Im Bereich des elektronischen Bauelements weist die Leiterplatte hierzu entweder ein sog. Kupfer-Inlay oder eine Anzahl an mit Metall gefüllten Mikro-Vias auf, welche die Wärme von dem elektronischen Bauelement weg leiten. Die Leiterplatte ist weiter über ein Wärmeleitmaterial, wie z.B. Wärmeleitpaste, mit einem Gehäusebauteil verbunden, welches mit der Umgebung als Wärmesenke in thermischer Verbindung steht, an die die Wärme abgegeben wird.

Diese Maßnahmen sind jedoch nicht ausreichend, um die in einem elektronischen Bauelement lokal entstehende Wärme wirkungsvoll abzuführen und damit den Anforderungen an die Zuverlässigkeit und die Lebensdauer des elektronischen Moduls gerecht zu werden.

Es ist daher Aufgabe der vorliegenden Erfindung, ein elektronisches Modul anzugeben, welches eine verbesserte Zuverlässigkeit und erhöhte Lebensdauer aufweist.

Diese Aufgabe wird gelöst durch ein elektronisches Modul gemäß den Merkmalen des Patenanspruchs 1. Vorteilhafte Ausgestaltungen ergeben sich aus den abhängigen Patentansprüchen.

Die Erfindung schafft ein elektronisches Modul, das eine Leiterplatte mit einer Leiterzugstruktur und zumindest einer Aufnahmefläche umfasst. Auf der zumindest einen Aufnahmefläche ist zumindest ein elektronisches Bauelement angeordnet und elektrisch mit der Leiterzugstruktur verbunden. Das elektronische Modul umfasst weiter eine in der Leiterplatte ausgebildete Kühlmittelführungsstruktur, in welcher im Betrieb des elektronischen Moduls ein Kühlmedium zirkuliert, wobei ein Abschnitt der Kühlmittelführungsstruktur im Bereich der zumindest einen Aufnahmefläche durch eine Wand der Leiterplatte und eine Fläche des elektronischen Bauelements ausgebildet ist. Es ist weiterhin vorgesehen, dass die Kühlmittelführungsstruktur an eine Wärmesenke angebunden ist. Die Wärmesenke kann beispielsweise ein Wärme leitendes Material sein, welches mit der Umgebung in Verbindung steht. Außerdem ist die Leiterplatte, optional über ein Wärmeleitmaterial, mit einem Gehäusebauteil Wärme leitend verbunden. Das Gehäusebauteil kann Bestandteil eines Gehäuses des Moduls sein, welches die Leiterplatte und die darauf angeordneten elektronischen Bauelemente mechanisch schützt. Als Wärmeleitmaterial kommt beispielsweise eine Wärmeleitpaste in Betracht. Die Kühlmittelführungsstruktur ist durch das Gehäusebauteil hindurch geführt und außerhalb des Gehäuses an die Wärmesenke angebunden.

Durch das erfindungsgemäße elektronische Modul kann die Wärme direkt vom Entstehungsort des oder der elektronischen Bauelemente durch das Kühlmedium wegtransportiert werden. Hierdurch wird die Absoluttemperatur in dem oder den elektronischen Bauelementen gesenkt, wodurch ihre Zuverlässigkeit erhöht wird. Die erfindungsgemäße Kühlmittelführungsstruktur, welche teilweise auch durch ein jeweiliges, zu kühlendes elektronisches Bauelement ausgebildet wird, lässt sich platzsparend in der Leiterplatte integrieren. Darüber hinaus entfallen im Vergleich zu herkömmlichen Lösungen zusätzliche Materialien oder Vorrichtungen zum Abtransport der in dem oder den elektronischen Bauelementen entstehenden Wärme.

Zweckmäßigerweise ist das zumindest eine elektronische Bauelement zur Bildung des Abschnitts der Kühlmittelführungsstruktur fluiddicht mit der Leiterplatte verbunden. Hierdurch ist sichergestellt, dass das in der Kühlmittelführungsstruktur zirkulierende Kühlmedium nicht aus dieser austreten und unerwünscht Kurzschlüsse hervorrufen kann.

Insbesondere strömt das Kühlmedium zur Kühlung direkt an dem zumindest einen Bauelement vorbei. Dies bedeutet, das Kühlmedium strömt ohne Zwischenschaltung eines Wärmeableiters das zu kühlende elektronische Bauelement an und transportiert die in diesem entstehende Wärme ab. Hierdurch ist eine höchstmögliche Kühleffizienz gewährleistet, da zwischen dem Kühlmedium und dem elektronischen Bauelement keine weiteren Materialien vorgesehen sind.

Gemäß einer weiteren Ausgestaltung ist die, einen Abschnitt der Kühlmittelführungsstruktur ausbildende, Fläche des elektronischen Bauelements zumindest ein Teil einer Hauptseite des elektronischen Bauelements. Zweckmäßigerweise ist das elektronische Bauelement auf der vom Kühlmedium angeströmten Hauptseite elektrisch kontaktiert. Diese auch als Kontaktseite bezeichnete Hauptseite kann beispielsweise über ein Ball Grid Array oder über Bonddrähte mit der Leiterplatte elektrisch verbunden sein. Im Falle einer elektrischen Verbindung mittels eines Ball Grid Array (BGA) strömt das Kühlmedium zwischen den Anschlusskugeln (Balls) zwischen der Wandung der Leiterplatte und der Kontaktseite des elektronischen Bauelements hindurch. Ist das elektronische Bauelement mit seiner Rückseite mit der Leiterplatte verbunden und über Bonddrähte elektrisch kontaktiert, so umströmt das Kühlmedium die Vorderseite des elektronischen Bauelements.

Die Kühlmittelführungsstruktur umfasst in einer Ausgestaltung als Kanäle ausgebildete Durchkontaktierungen (sog. Vias), welche sich zumindest abschnittsweise senkrecht zu einer jeweiligen Aufnahmefläche durch die Leiterplatte erstrecken und einen Zu- und Ablauf für das Kühlmedium ausbilden. Der Durchmesser der Durchkontaktierungen ist dabei bevorzugt derart gewählt, dass das Kühlmedium ohne nennenswerten Strömungswiderstand durch die Durchkontaktierungen fließen kann. Zwischen einen Zu- und Ablauf kann eine beliebige Anzahl an zwischen einer Wand der Leiterplatte und einer Fläche des elektronischen Bauelements ausgebildeten Kühlmittelführungsabschnitten angeschlossen sein. Die Kühlmittelführungsstruktur weist somit entweder für jedes elektronische Bauelement einen Zu- und Ablauf auf. Alternativ kann an einem Zu- und Ablauf eine Mehrzahl zu kühlender elektronischer Bauelemente angeschlossen sein.

Zweckmäßigerweise sind die Wandungen der Durchkontaktierungen mit einer dichtenden Schicht bekleidet. Die Schicht kann beispielsweise aus Kupfer bestehen, welche zusammen mit den Durchkontaktierungen (Vias) zur elektrischen Leitungsführung hergestellt werden kann.

Um eine Beschädigung des oder der zu kühlenden elektronischen Bauelemente aufgrund eines durch das Kühlmedium herbeigeführten Kurzschlusses zu vermeiden, ist weiter vorgesehen, dass das Kühlmedium elektrisch isolierend ist. Beispielsweise kann als Kühlmedium Glykol gewählt werden.

Die Zirkulation des Kühlmediums ist wahlweise durch Eigenkonvektion oder durch eine Pumpe bewirkbar. Eine derartige Pumpe kann beispielsweise auf der Leiterplatte oder außerhalb des Gehäuses, z.B. in räumlicher Nähe zu der Wärmesenke, an die Kühlmittelführungsstruktur angeschlossen sein.

Die Erfindung wird nachfolgend näher anhand von Ausführungsbeispielen in der Zeichnung erläutert. Es zeigen:
- Fig. 1: ein erstes Ausführungsbeispiel eines erfindungsgemäßen elektronischen Moduls, und
- Fig. 2: ein zweites Ausführungsbeispiel eines erfindungsgemäßen elektronischen Moduls.

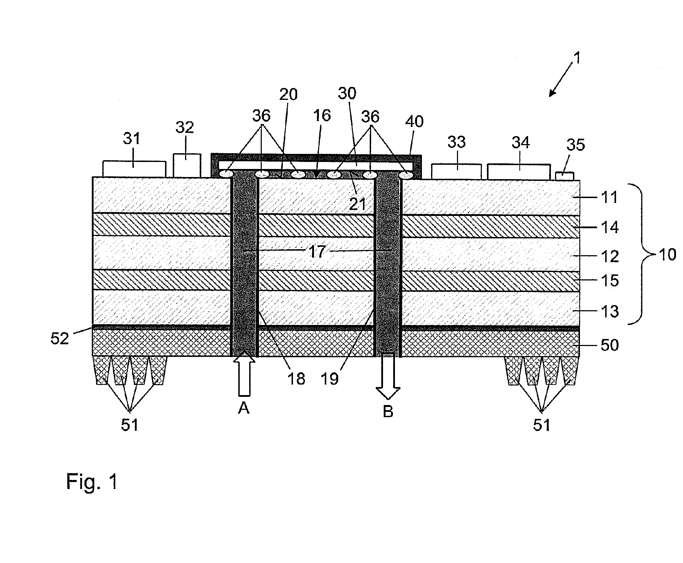

Fig. 1 zeigt in einer schematischen Querschnittsdarstellung ein erfindungsgemäßes elektronisches Modul 1. Das Modul 1 umfasst eine Leiterplatte 10 aus beispielhaft drei Leiterplattenschichten 11, 12, 13, welche jeweils über leitende Schichten 14, 15 miteinander verbunden sind. Die im Ausführungsbeispiel dargestellte Leiterplatte 10 stellt somit eine MultiLayer-Leiterplatte dar. Selbstverständlich könnte ein erfindungsgemäßes elektronisches Modul 1 auch lediglich eine einzige Leiterplattenschicht umfassen. Ebenso könnte eine andere Anzahl an Leiterplattenschichten - mit oder ohne dazwischen liegenden, leitenden Schichten - vorgesehen sein.

Ebenfalls lediglich beispielhaft ist auf einer Aufnahmefläche 16 auf einer Hauptseite der Leiterplatte 10 ein zu kühlendes elektronisches Bauelement 30 angeordnet. Auf der gleichen Hauptseite der Leiterplatte 10 sind weitere elektronische Bauelemente 31, 32, 33, 34, 35 vorgesehen, welche aufgrund ihrer Bauart und/oder Betriebsweise keiner erfindungsgemäßen Kühlung bedürfen. Obwohl in der Querschnittsdarstellung der Fig. 1 nicht ersichtlich, sind die elektronischen Bauelemente 30, 31, 32, 33, 34, 35 über eine nicht dargestellte Leiterzugstruktur auf und/oder in der Leiterplatte 10 elektrisch miteinander verbunden.

In der Leiterplatte 10 ist unterhalb der Aufnahmefläche 16 eine Kühlmittelführungsstruktur 17 ausgebildet. Die Kühlmittelführungsstruktur 17 umfasst im Ausführungsbeispiel einen Kanal 18 sowie einen Kanal 19, welche sich jeweils im Wesentlichen senkrecht durch die Leiterplatte 10 hindurch erstrecken. Entgegen der zeichnerischen Darstellung der Fig. 1 brauchen sich die Kanäle 18, 19 nicht entlang einer einzigen Achse durch die Leiterplatte 10 hindurch erstrecken. Vielmehr können die Kanäle 18, 19 im Grunde beliebig durch die Leiterplatte 10 geführt sein. Lediglich in der Leiterplattenschicht 11, auf welcher das zu kühlende elektronische Bauelement 30 angeordnet ist, ist es erforderlich, dass die Kanalabschnitte der Kanäle 18, 19 im Bereich der Aufnahmefläche 16 des Bauelements 30 angeordnet sind. Mit anderen Worten müssen diese Kanalabschnitte innerhalb eines Umrisses des Bauelements 30 vorgesehen sein, damit eine Abdichtung gegenüber der Umwelt erfolgen kann.

Die Kanäle 18, 19 sind als sog. Durchkontaktierungen (Vias) ausgebildet, deren Wandungen mit einer dichtenden Schicht aus Kupfer ausgekleidet sind. Diese dichtende Schicht kann zusammen mit eventuell weiterhin vorgesehenen Vias zur elektrischen Leitungsführung hergestellt werden. Der Kanal 18 dient als Zulauf (Pfeil A) für ein in der Kühlmittelführungsstruktur zirkulierendes Kühlmedium. Der Kanal 19 dient als Ablauf (Pfeil B) für das Kühlmedium. Ein Abschnitt der Kühlmittelführungsstruktur 17 ist im Bereich der Aufnahmefläche 16 durch eine Wand 20 der Leiterplatte 10 und eine Fläche 21 des elektronischen Bauelements 30 ausgebildet.

Aufgrund der im Ausführungsbeispiel gewählten elektrischen Kontaktierung des Bauelements 30 über ein Ball Grid Array (BGA) strömt das Kühlmedium in den Kanal 18 hinein, zwischen den "Balls" 36 hindurch und durch den Kanal 19 ab. Hierdurch kann die in dem elektronischen Bauelement 30 entstehende Wärme über das Kühlmedium direkt abtransportiert werden. Dabei strömt das Kühlmedium zur Kühlung des Bauelements 30 direkt, d.h. ohne Zwischenschaltung eines weiteren Wärmeableitelements, an diesem vorbei. Da aufgrund der im Ausführungsbeispiel gewählten elektrischen Kontaktierung die Gefahr von Kurzschlüssen zwischen jeweiligen "Balls" besteht, wird eine elektrisch isolierende Kühlflüssigkeit aus Glykol verwendet.

Damit weiterhin sichergestellt ist, dass das in der Kühlmittelführungsstruktur 17 zirkulierende Kühlmedium im Bereich der Aufnahmefläche 16 nicht aus dem Kanalsystem austreten kann, ist das elektronische Bauelement 30 mit einem Verguss 40 versehen, welcher die Kühlmittelführungsstruktur gegenüber der Umgebung fluiddicht abdichtet.

Die Leiterplatte 10 ist über ein Wärmeleitmaterial 52, z.B. eine Wärmeleitpaste, auf einem Gehäusebauteil 50 angeordnet. Von der Leiterplatte 10 abgewandt sind auf dem Gehäusebauteil 50 Kühlrippen 51 vorgesehen. Auf der gleichen Seite des Gehäusebauteils 50 ist vorzugsweise eine Wärmesenke vorgesehen, an welche die Kühlmittelführungsstruktur 17 angebunden ist. Um die Zirkulation des Kühlmediums in der Kühlmittelführungsstruktur sicherstellen zu können, kann eine Pumpe vorgesehen sein, welche beispielsweise ebenfalls auf der von der Leiterplatte 10 abgewandten Seite des elektronischen Moduls 1 vorgesehen ist. Gegebenenfalls ist es ausreichend, die Zirkulation des Kühlmediums durch Eigenkonvektion sicherzustellen.

In einer in der Figur nicht dargestellten Ausgestaltung können auch die benachbart zu dem elektronischen Bauelement 30 auf der Leiterplatte 10 angeordneten Bauelemente 31, 32, 33, 34, 35 wärmetechnisch an die Kühlmittelführungsstruktur 17 angebunden sein. Zu diesem Zweck kann beispielsweise in der Leiterplattenschicht 11 ein Kupferinlay oder eine Anzahl an Mikrovias vorgesehen sein, welche die Wärme zu der leitenden Schicht 14 führen. Die leitende Schicht 14 ist wiederum (aufgrund ihres hohen Metallanteils) Wärme leitend mit der Kühlmittelführungsstruktur 17 verbunden.

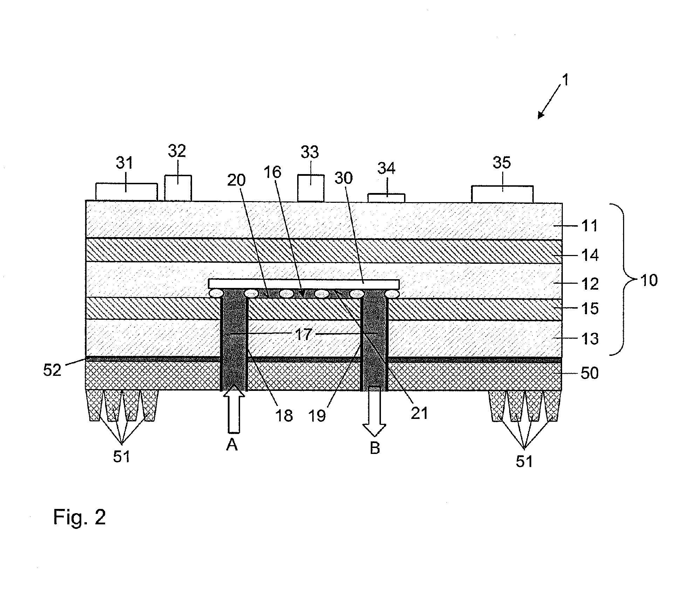

Fig. 2 zeigt ein weiteres Ausführungsbeispiel, das sich von dem in Fig. 1 gezeigten Ausführungsbeispiel darin unterscheidet, dass das zu kühlende elektronische Bauelement 30 im Inneren der Leiterplatte 10 angeordnet ist. Genauer ist das Bauelement 30 im Bereich der Leiterplattenschicht 12 angeordnet. Das Bauelement 30 ist wiederum über ein Ball Grid Array mit einer Leiterzugstruktur der leitenden Schicht 15 verbunden. Der Vorteil dieser Ausführungsvariante besteht darin, dass auf der Außenseite der Leiterplatte 10 eine größere Anzahl an weiteren Bauelementen angeordnet werden kann. Darüber hinaus ist es nicht notwendig, den durch die Wand 20 der Leiterplatte und die Fläche 21 des elektronischen Bauelements 30 gebildeten Abschnitt der Kühlmittelführungsstruktur gegenüber der Umgebung abzudichten. Es kann somit auf den Verguss des zu kühlenden elektronischen Bauelements 30 verzichtet werden.

In den in den Figuren 1 und 2 gezeigten Ausführungsbeispielen erfolgt eine Kontaktierung des zu kühlenden elektronischen Bauelements 30 über ein Ball Grid Array. Selbstverständlich kann eine elektrische Kontaktierung des zu kühlenden Bauelements auch über Bonddrähte erfolgen, welche dann flüssigkeitsdicht gegenüber ihrer Umgebung verkapselt sein sollten. Der Vorteil des erfindungsgemäßen elektronischen Moduls besteht darin, dass Wärme direkt vom Entstehungsort wegtransportiert werden kann. Die absolute Temperatur in den zu kühlenden Bauelementen kann dadurch gesenkt werden, wodurch ihre Zuverlässigkeit erhöht wird. Durch die Verwendung von Vias und Bauelementen als Kühlkanalabschnitte kann die Kühlmittelführungsstruktur platzsparend in die Leiterplatte integriert werden. Darüber hinaus sind keine zusätzlichen Materialien oder Bauelemente erforderlich.

## Patentansprüche

1. Elektronisches Modul (1), gebildet mit:
- einer Leiterplatte (10) mit einer Leiterzugstruktur,
- zumindest einem elektronisches Bauelement (30), das auf einer Aufnahmefläche (16) der Leiterplatte (10) angeordnet und elektrisch mit der Leiterzugstruktur verbunden ist,
- einer in der Leiterplatte (10) ausgebildeten, an eine Wärmesenke angebunden Kühlmittelführungsstruktur (17), in welcher im Betrieb des elektronischen Moduls (1) ein Kühlmedium zirkuliert, wobei ein Abschnitt der Kühlmittelführungsstruktur (17) im Bereich der zumindest einen Aufnahmefläche (16) durch eine Wand (20) der Leiterplatte (10) und eine Fläche (21) des elektronischen Bauelements (30) ausgebildet ist,
**dadurch gekennzeichnet,**
**dass** die Leiterplatte (10), optional über ein Wärmeleitmaterial (40), mit einem Gehäusebauteil (50) Wärme leitend verbunden ist und
**dass** die Kühlmittelführungsstruktur (17) durch das Gehäusebauteil (50) hindurch geführt und außerhalb des Gehäuses an die Wärmesenke angebunden ist.

2. Modul nach Anspruch 1, bei dem das zumindest eine elektronische Bauelement (30) zur Bildung des Abschnitts der Kühlmittelführungsstruktur (17) fluiddicht mit der Leiterplatte (10) verbunden ist.

3. Modul nach Anspruch 1 oder 2, bei dem das Kühlmedium zur Kühlung direkt an dem zumindest einen Bauelement (30) vorbeiströmt.

4. Modul nach einem der vorhergehenden Ansprüche, bei dem die, einen Abschnitt der Kühlmittelführungsstruktur (17) ausbildende, Fläche (21) des elektronischen Bauelements (30) zumindest ein Teil einer Hauptseite des elektronischen Bauelements (30) ist.

5. Modul nach Anspruch 4, bei dem das elektronische Bauelement (30) auf der von Kühlmedium angeströmten Hauptseite elektrisch kontaktiert ist.

6. Modul nach einem der vorhergehenden Ansprüche, bei dem die Kühlmittelführungsstruktur (17) als Kanäle (18, 19) ausgebildete Durchkontaktierungen (Vias) umfasst, welche sich zumindest abschnittsweise senkrecht zu einer jeweiligen Aufnahmefläche (16) durch die Leiterplatte (10) erstrecken und einen Zu- und Ablauf für das Kühlmedium ausbilden.

7. Modul nach Anspruch 6, bei dem die Wandungen der Durchkontaktierungen mit einer dichtenden Schicht ausgekleidet sind.
